# FASCICULE DE BREVET EUROPEEN

(11) **EP 1 903 276 B1**
(45) Date de publication et mention de la délivrance du brevet: **31.07.2019**
(21) Numéro de dépôt: 07116264.8
(22) Date de dépôt: 12.09.2007
(51) Int. Cl.: F21K 9/00, H05K 1/02, H05K 1/18, H05K 3/00, F21V 29/63, F21V 29/70, F21Y 115/10

(54) **Dispositif d'éclairage ou de feu pour véhicule**
Beleuchtungsvorrichtung oder Scheinwerfer für KFZ
Lighting device or headlamp for vehicle

(30) Priorité: 22.09.2006 FR 0608344
(43) Date de publication de la demande: 26.03.2008
(73) Titulaire: VALEO VISION, 93012 Bobigny (FR)
(72) Inventeur: Nicolai, Jean-Marc, 92400, Courbevoie (FR); Richard, Stéphane, 93700, Drancy (FR); Ho, Pascal, 78530, Buc (FR)
(74) Mandataire: Oggioni, Baptiste

(56) Documents cités:
- WO-A-95/02504
- WO-A-2006/089512
- WO-A-2006/097067
- DE-A1-102004 036 157
- US-A- 4 755 249
- US-A1- 2005 199 899
- "OSTAR - Projection - Lead (Pb) Free Product - RoHS Compliant - LE AB A2A" 13 septembre 2006 (2006-09-13), OPTO SEMICONDUCTORS OSRAM, XX, XX, PAGE(S) 1-17 , HTTP://CATALOG.OSRAM-OS.COM/MEDIA/_EN/GRAP HICS/00039578_0.PDF , XP007901718 * le document en entier *
- MARK A OCCHIONERO ET AL: "AlSiC for Optoelectronic Thermal Management and Packaging Designs" INTERNET CITATION, [Online] 5 septembre 2003 (2003-09-05), XP007901711 Extrait de l'Internet: URL:http://www.alsic.com/papers/alsic_opto electronic.pdf> [extrait le 2007-02-09]

## Description

La présente invention concerne un dispositif d'éclairage ou de feu pour véhicule comprenant un module d'éclairage.

Selon un état de la technique connu, un tel module d'éclairage comporte :
- au moins un dispositif de lumière, comprenant une unité d'émission de lumière,
- deux terminaisons électriques métalliques connectées à l'unité d'émission de lumière,

Le dispositif de lumière est soudé sur un support par une technique dite de refusion dans laquelle :
- une pâte à braser conductrice chauffée composée d'étain et de plomb ou d'étain et d'argent est disposée dans une cavité du support,
- le dispositif de lumière est disposé sur cette pâte à braser qui chauffée est liquide,
- la pâte à braser est par la suite refroidie et se durcit; le dispositif de lumière est en conséquence fixé au support et est ainsi connecté de façon électrique au support. Un tel module d'éclairage dans un dispositif d'éclairage ou de feu pour véhicule est décrit dans le document DE102004036157 A1.

Une telle solution présente l'inconvénient suivant. Le positionnement du dispositif de lumière qui est effectué est un positionnement qui n'est pas précis en raison de la pâte liquide chauffée en mouvement. Par ailleurs, la technique de refusion nécessite de chauffer la pâte liquide à des températures très élevées de l'ordre de 240°C. Ces températures ne sont pas supportées par tous les dispositifs de lumière et elles risquent donc d'endommager certains de ces dispositifs.

La présente invention apporte remède à ces inconvénients de l'état de la technique.

En effet, elle concerne un dispositif d'éclairage ou de feu pour véhicule selon la revendication indépendante 1 comprenant un module d'éclairage comprenant
- au moins un dispositif de lumière comprenant au moins une unité d'émission de lumière,
- deux terminaisons électriques connectées à l'unité d'émission de lumière,
- une plaque conductrice comprenant une cavité pour recevoir le dispositif de lumière,
caractérisé en ce qu'il comporte en outre :
- un support dissipateur de chaleur du dispositif de lumière, et
- une pièce adhésive placée entre le support dissipateur et la plaque conductrice,
et en ce que les deux terminaisons électriques sont connectées à la plaque conductrice par connexion filaire point à point.

Comme on le verra en détail plus loin, le fait d'utiliser une pièce adhésive permet de positionner et d'assembler de façon précise un dispositif de lumière sur le support dissipateur et par rapport à la plaque conductrice. De plus, il n'est pas nécessaire de chauffer cette pièce adhésive pour faire adhérer le dispositif de lumière ce qui évite d'endommager ce dernier. Enfin, le fait d'utiliser une pièce adhésive et la connexion filaire point à point en combinaison permet de réduire le nombre de pièces utilisées dans le module d'éclairage.

Par plaque conductrice on entend une plaque permettant de conduire le courant jusqu'au composant électroniques, notamment grâce à des pistes électriques comprises dans cette plaque conductrice. Par exemple, cette plaque conductrice peut être un circuit imprimé ou PCB «Printed Circuit Board», par exemple de type FR4 ou encore des barres de cuivre.

La pièce adhésive est le plus souvent une pièce intermédiaire. Par ses propriétés adhésives, elle va adhérer aux pièces avec lesquelles elle est mise en contact.

Selon des modes de réalisation non limitatifs, le module d'éclairage comporte les caractéristiques supplémentaires suivantes :
- La cavité comprise dans la plaque conductrice est traversante, de manière à ce que ledit dispositif de lumière adhère à la dite pièce adhésive. Ainsi, la pièce adhésive sert de conducteur thermique entre le dispositif de lumière et le support dissipateur thermique, permettant une évacuation de la chaleur produite par le dissipateur thermique. Cela permet également de positionner avec précision et de fixer directement le dispositif de lumière, sur le support et dans la cavité de la plaque conductrice.
- Selon une première variante, le module d'éclairage comporte en outre une couche de colle disposée dans la cavité autour du dispositif de lumière. Cela permet figer la fixation du dispositif de lumière par rapport à la cavité de la plaque conductrice.
- La couche de colle est une colle se solidifiant à température ambiante. Par température ambiante, on entend une température que l'on rencontre le plus communément dans un atelier ou opèrent des êtres humains sans protection thermique spécifique. On peut considérer qu'une température ambiante est comprise entre 10 et 50 degrés Celcius, le plus souvent entre 20 et 30 degrés Celcius.
- La couche de colle est une colle époxy ou un mastic polyester.
- Selon une deuxième variante, le dispositif de lumière comporte en outre un segment isolé pour une fixation mécanique sur la plaque conductrice ou sur le support dissipateur. Cela apporte un moyen de fixation mécanique supplémentaire.
- Le support dissipateur comporte un radiateur à ailettes et/ou une couche graphite. Ce sont de très bons dissipateurs thermiques.
- La couche graphite peut être anisotrope. Ceci permet de privilégier une direction de dissipation de chaleur.
- La plaque conductrice comporte deux mires de positionnement. Ce sont des mires de calibrage pour le positionnement du dispositif de lumière par rapport à la plaque conductrice.
- La pièce adhésive se présente sous forme d'une feuille. Cela évite d'obturer le cône de lumière émis par le dispositif de lumière.
- La pièce adhésive est adhésive double face. Cela permet également d'assembler la plaque conductrice au support dissipateur.
- La pièce adhésive permet de positionner le dispositif de lumière dans la cavité de la plaque conductrice de manière précise. Ceci permet d'obtenir un positionnement très précis et définitif du dispositif de lumière.
- La pièce adhésive permet d'assembler le dispositif de lumière sur le support dissipateur de manière précise. Ceci permet de parfaire le positionnement très précis et définitif du dispositif de lumière.
- La pièce adhésive est composée d'un matériau pouvant adhérer uniquement par pression. La pièce adhésive n'a pas besoin d'être polymérisée pour adhérer contrairement à une colle. L'adhésion au support dissipateur est effectuée par pression ce qui facilite les procédés de fabrication et donc entraîne un coût moindre.
- La pièce adhésive est composée d'une base acrylique, d'un film en polyéthylène naphtalate ou d'un film en polyéthylène téréphtalate. Ces composants permettent d'obtenir une bonne tenue mécanique et une bonne souplesse de la pièce. Ainsi, les vibrations mécaniques dues à l'assemblage des liaisons électriques par connexion filaire sont mieux absorbées. On obtient ainsi une bonne fiabilité mécanique.
- La pièce adhésive est composée d'une base acrylique comprenant des charges céramiques, permettant ainsi de diminuer la résistance thermique de la pièce adhésive.
- Le module d'éclairage comporte une pluralité de dispositifs de lumière. C'est souvent le cas lorsqu'il est utilisé dans un dispositif de feu pour véhicule par exemple.

L'invention concerne un dispositif de feu pour véhicule, tel qu'un feu de signalisation, ou un dispositif d'éclairage, tel qu'un projecteur avant de véhicule, le dispositif de feu ou le dispositif d'éclairage comprenant un module d'éclairage selon l'une quelconque des caractéristiques précédentes.

D'autres caractéristiques et avantages de la présente invention seront mieux compris à l'aide de la description et des dessins parmi lesquels :
- la Fig. 1 représente schématiquement un dispositif de feu de véhicule comprenant un module d'éclairage selon l'invention ;
- la Fig. 2 représente schématiquement une coupe transversale d'un premier mode de réalisation non limitatif du module d'éclairage selon l'invention ;
- la Fig. 3 représente schématiquement une vue en perspective simplifiée d'un premier mode de réalisation non limitatif dispositif de lumière utilisé dans un module d'éclairage selon l'invention ;
- la Fig. 4 représente schématiquement une coupe transversale simplifiée du dispositif de lumière de la Fig. 3 ;
- la Fig. 5 représente schématiquement une vue en perspective simplifiée d'un deuxième mode de réalisation non limitatif dispositif de lumière utilisé dans un module d'éclairage selon l'invention ; et
- la Fig. 6 représente schématiquement une coupe transversale d'un deuxième mode de réalisation non limitatif du module d'éclairage selon l'invention.

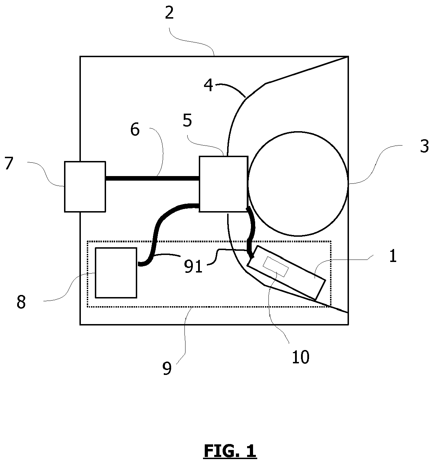

A la Fig. 1 est représenté un module d'éclairage 1 dans le cadre d'une application non limitative de feu 2 de véhicule. Le feu 2 est par exemple, un feu de signalisation (veilleuses, codes, feux arrière) ou d'éclairage appelé projecteur (phare). Le module d'éclairage 1 permet d'effectuer l'éclairage de jour et/ou de nuit.

Ainsi, un tel feu 2 comporte principalement :
- une lampe de type halogène 3 enfermée dans un boîtier et disposée selon une configuration géométrique déterminée avec un réflecteur 4 ;
- au moins un module d'éclairage 1, enfermé également dans le boîtier, comprenant au moins un dispositif de lumière 10. Selon le type de fonction voulue (signalisation, éclairage...) et de puissance d'un dispositif de lumière 10, le module d'éclairage 1 comporte une ou plusieurs dispositifs de lumière 10 ;
- un premier connecteur 5 solidaire du boîtier sur lequel est montée la lampe halogène 3 par son culot, ledit connecteur étant connecté par un faisceau d'alimentation 6 à un deuxième connecteur 7;
- le deuxième connecteur 7 permet de connecter un module de contrôle 8 disposé sur une carte électronique à un deuxième faisceau d'alimentation (non représenté); et
- un dispositif de commande 9 comprenant le module d'éclairage 1 et le module de contrôle 8 qui sont reliés entre eux par un faisceau de communication 91.

Le feu 2, est de manière connue, connecté à une unité de contrôle (non représentée) d'un réseau de bord (non représenté) du véhicule via le deuxième faisceau d'alimentation. Bien entendu, le feu 2 peut comporter une pluralité de modules d'éclairage 1. Dans cet exemple, la lampe halogène 3 sert d'éclairage de jour, et le module d'éclairage 1 sert d'éclairage de nuit. Bien entendu, on pourrait très bien voir ces deux fonctions effectuées uniquement par le module d'éclairage 1 et donc ne pas avoir besoin de lampe halogène 3.

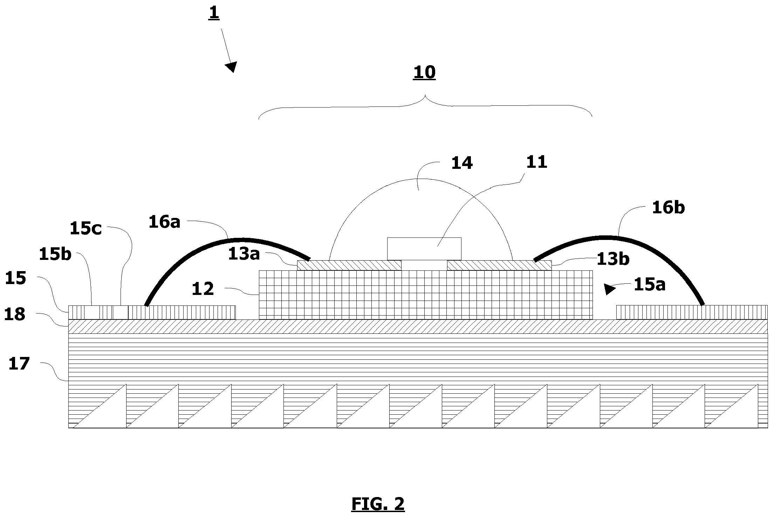

Un premier mode de réalisation du module d'éclairage 1 est représenté en coupe à la Fig. 2.

Il comporte :
- une pluralité de dispositifs de lumière 10, ici un seul est représenté ;
- une liaison électrique conductrice 16 associée à chaque terminaison électrique 13 d'un dispositif de lumière 10, soit deux liaisons électriques 16a et 16b pour un dispositif de lumière 10 dans l'exemple pris ;
- un support dissipateur 17 sur lequel sont disposés les dispositifs de lumière 10; ce support permet de refroidir les dispositifs de lumière 10 ;
- une plaque conductrice 15 comprenant des pistes électriques (non représentées), et
- une pièce adhésive 18 placée entre le support dissipateur 17 et la plaque conductrice 15.

Les différents éléments du module d'éclairage 1 sont décrits en détail ci-après.

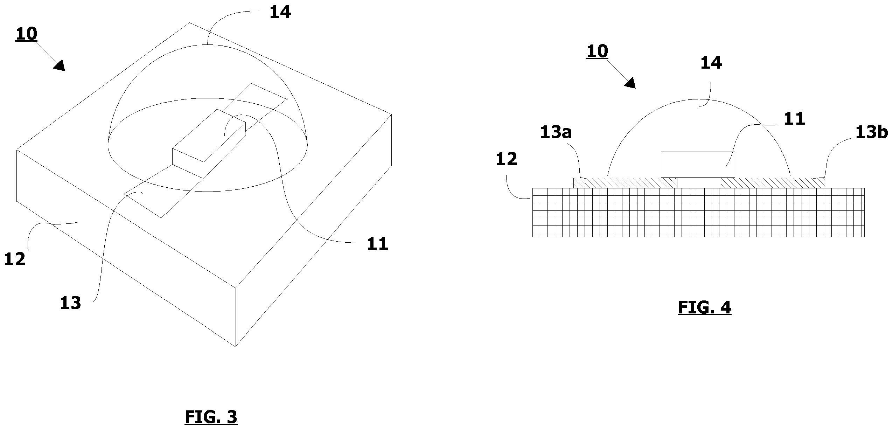

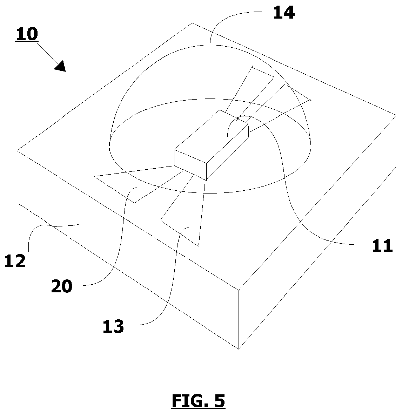

A la Fig. 3 et à la Fig. 5, sont représentés un premier et un deuxième modes de réalisation non limitatifs d'un dispositif de lumière 10. Un tel dispositif de lumière 10 est, dans des modes de réalisation non limitatifs, une diode luminescente de type LED («light emitting diode»), une diode super luminescente (SLD), une diode laser, ou encore une diode luminescente organique (OLED). Dans la suite de la description, on prendra l'exemple des LED. On notera qu'un dispositif de lumière 10 comporte une ou plusieurs diodes. Dans la description, on prendra l'exemple non limitatif d'un dispositif 10 avec une seule diode. Généralement, ces dispositifs LED 10 sont de forte puissance pour une application véhicule. Dans un exemple non limitatif ils sont alimentés à 1A sous 16V.

Selon le premier mode de réalisation illustré à la Fig. 3, le dispositif de lumière LED 10 comporte :
- au moins une unité d'émission de lumière 11; de manière non limitative, cette unité d'émission est un semi-conducteur qui émet de la lumière qui est dirigée dans une direction grâce à un dispositif de concentration de lumière (non représenté).
- un corps ou substrat 12 sur lequel est fixée l'unité d'émission de lumière 11,
- au moins une terminaison électrique 13 connectée à l'unité d'émission de lumière 11 et en contact avec le substrat 12; ici, il y a deux terminaisons électriques 13a et 13b, appelées également électrodes. Comme on peut le voir sur la coupe transversale de la Fig. 4, les deux électrodes 13a et 13b sont fixées sur le substrat 12 et sont connectées au semi-conducteur 11.

Dans ce mode de réalisation non limitatif, le dispositif de lumière 10 est un composant monté en surface ou CMS, (SMD «Surface Mounted Device» en anglais). Il comporte ainsi une coupole transparente 14 pour protéger l'unité d'émission de lumière 11. Cette coupole comporte le dispositif de concentration de lumière et forme ainsi avec le semi-conducteur une diode.

Selon le deuxième mode de réalisation illustré à la Fig. 5, le dispositif de lumière 10 comporte les mêmes éléments que dans le premier mode de réalisation et en outre une zone de fixation mécanique 20 supplémentaire. Cette zone de fixation permet d'avoir un endroit de fixation mécanique supplémentaire du dispositif de lumière 10 sur une plaque conductrice 15 ou sur un support dissipateur 17 (décrits par la suite) en collant cette zone de fixation sur cette plaque 15 ou sur ce support 17.

Les liaisons électriques 16a et 16b permettent d'établir un contact électrique entre les terminaisons électriques 13a et 13b du dispositif de lumière 10 et la plaque conductrice 15 de sorte que le courant puisse être fourni à l'unité d'émission de lumière 11. Ces liaisons 16a et 16b sont, dans un exemple non limitatif, des fils en aluminium, en or ou en nickel. Le procédé permettant de créer ces liaisons s'appelle connexion filaire point à point ou «wire bonding» en anglais.

Le support dissipateur 17 peut dans des exemples non limitatifs être :
- un radiateur à ailettes comme représenté à la Fig. 2,
- une couche graphite thermique anisotrope ou non (dans le cas anisotrope, elle est dissipatrice de chaleur dans un axe et isolante dans l'autre axe),
- ou encore une combinaison des deux.

L'avantage de la couche graphite par rapport à un radiateur en aluminium est une meilleure conductivité.

La plaque conductrice 15 comporte des pistes électriques (non représentées). Elle permet notamment de connecter les dispositifs de lumière à une source d'alimentation (non représentée) et de véhiculer un courant électrique vers le dispositif de lumière 10 au moyen de pistes électriques d'alimentation. Elle permet également de véhiculer d'autres informations telles que, dans un exemple non limitatif, des informations de diagnostic concernant ces dispositifs de lumière 10.

Dans un mode de réalisation non limitatif, la plaque conductrice est par exemple un PCB «Printed Circuit Board», par exemple de type FR4 ou encore des barres de cuivre. Cette plaque conductrice 15 comporte des cavités 15a pour recevoir les dispositifs de lumière 10.

De manière non limitative, la plaque conductrice 15 comporte deux mires de positionnement 15b et 15c permettant de calibrer selon les axes X et Y des machines permettant un positionnement des dispositifs de lumière 10 et permettant d'effectuer les connexions électriques filaires point à point «wire bonding». La deuxième mire de calibrage 15c est située à une distance précise déterminée de la première mire 15b. Comme les dispositifs de lumière 10 sont positionnés par rapport à cette plaque conductrice 15, de manière non limitative, la plaque conductrice 15 peut également intégrer des solutions de positionnement d'autres éléments coopérant avec le module d'éclairage 1 tel que le positionnement d'un réflecteur par exemple.

La pièce adhésive 18 permet :
- de positionner les dispositifs de lumière 10 dans les cavités de la plaque conductrice 15 de manière précise,
- d'assembler ces dispositifs de lumière 10 sur le support dissipateur 17 de manière précise,
- d'assembler le support dissipateur 17 et la plaque conductrice 15 ensemble, et
- de maintenir un échange thermique entre le dispositif de lumière 10 et le support dissipateur 17 ; cette pièce fait donc également office de dissipateur thermique.

La pièce adhésive 18 est adhésive double face. Cela permet d'avoir une meilleure conductivité thermique pour le module d'éclairage par rapport à une solution mettant en oeuvre une simple face adhésive plus colle thermique ou plus vissage mécanique.

Dans un premier mode de réalisation non limitatif, la pièce adhésive 18 est composée d'une base acrylique. Cela permet une bonne tenue mécanique et une bonne souplesse de la pièce 18. Ainsi, les vibrations mécaniques dues à l'assemblage des liaisons électriques 16a et 16b sur les électrodes 13a et 13b sont mieux absorbées ce qui évite au dispositif de lumière 10 de se déplacer lorsqu'il a été placé dans la cavité correspondante 15a de la plaque conductrice 15. On obtient ainsi une bonne fiabilité mécanique.

On rappellera que lorsque les électrodes 13a et 13b sont reliées aux pistes électriques du support PCB 15, par des liaisons électriques 16a et 16b créées par le procédé de «wire bonding», il y a des vibrations mécaniques allant jusqu'à 60Hz.

Ainsi, cette pièce adhésive 18 permet d'éviter des ruptures mécaniques dues à des fortes variations thermiques appliquées sur le dispositif de lumière 10 et le support dissipateur 17 qui ont des coefficients de dilatation différents, ces derniers engendrant des contraintes locales.

Dans une variante de réalisation non limitative, la base acrylique comporte des charges céramiques ce qui a pour effet de diminuer sa résistance thermique et donc d'améliorer l'échange thermique entre le dispositif de lumière 10 et le radiateur 17.

Dans d'autres modes de réalisations non limitatifs, la pièce adhésive 18 est composée de film isolant (PEN polyéthylène naphtalate ou PET polyéthylène téréphtalate par exemple) ou de silicone. Ces composants permettent toujours d'obtenir une bonne tenue mécanique et une bonne souplesse de la pièce.

On notera que la composition chimique de la pièce adhésive 18 est choisie de manière à ce qu'elle n'ait pas besoin d'être polymérisée pour adhérer contrairement à une colle. L'adhésion au support dissipateur 17 est effectuée par pression et est pratiquement instantanée ce qui facilite les procédés de fabrication et donc entraîne un coût moindre. En pratique, de façon non limitative, on préconisera un kilogramme en moyenne comme poids à appliquer.

En général, cette pièce adhésive se présentera sous forme d'une fine feuille de l'ordre de quelques microns.

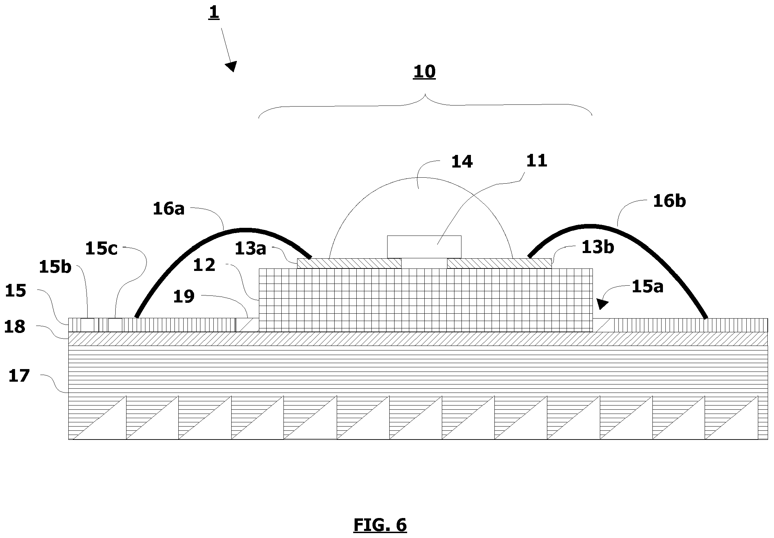

Un deuxième mode de réalisation du module d'éclairage 1 est représenté en coupe à la Fig. 6. II est basé sur le premier mode de réalisation. De plus, dans ce deuxième mode de réalisation, le module d'éclairage 1 comporte en outre une couche de colle 19 dans les cavités de la plaque conductrice 15 autour des dispositifs de lumière 10, c'est-à-dire dans les jeux existant entre un dispositif de lumière 10 et le rebord de la cavité 15a de la plaque conductrice 15 correspondante. Cette couche de colle 19 est ainsi disposée après le positionnement des dispositifs de lumière 10 dans les cavités sur la pièce adhésive 18. C'est une fixation mécanique supplémentaire qui fige le positionnement du dispositif de lumière 10 par rapport à la plaque conductrice 15. Cette couche de colle 19 n'ayant pas de rôle dissipateur thermique, il n'est pas nécessaire de trop la chauffer. On pourra choisir par exemple une colle qui se solidifie à température ambiante telle que les colles époxy, les mastics polyesters .... On notera que cette colle peut être remplacée par le point de fixation mécanique supplémentaire 20 du dispositif de lumière 10 vu précédemment.

Ainsi, grâce à un élément unique, la pièce adhésive 18, on maintient l'échange thermique entre le dispositif de lumière 10 et le radiateur 17 et on positionne et on assemble de façon précise ce dispositif de lumière 10 par rapport à la plaque conductrice 15 et sur le support dissipateur 17, ce qui n'est pas le cas avec simplement de la colle ou des pattes métalliques. Ainsi, on a un bon référencement du dispositif de lumière 10.

On rappelle que dans les exemples illustrés, le module d'éclairage 1 n'avait qu'un seul dispositif de lumière 10, mais bien entendu, l'ensemble de la description s'applique également à des modules d'éclairage 1 comportant plusieurs dispositifs de lumière 10.

En conclusion, le module d'éclairage 1 selon l'invention présente les avantages suivants.
a) il comporte des dispositifs de lumière 10 assemblés sur le support dissipateur 17 et positionnés précisément par rapport à la plaque conductrice 15, sans avoir été endommagés par des températures élevées.
b) il comporte des éléments, la pièce adhésive 18 et le support dissipateur 17, permettant d'assurer une bonne dissipation de chaleur des dispositifs de lumière 10 et donc d'avoir un bon échange thermiques entre tous ces éléments.
c) il permet d'assurer un bon calibrage des dispositifs de lumière 10 lors de la pose et donc un positionnement très précis et définitif de ces dispositifs de lumière 10.
d) il comporte des dispositifs de lumière dont les cônes de lumière ne sont pas réduits, et ce grâce à l'épaisseur de quelques microns de la pièce adhésive 18.
e) le module d'éclairage 1 par rapport à l'état de l'art antérieur n'est pas plus lourd en raison de la pièce adhésive 18 qui est très fine et très légère. Dans un exemple non limitatif, son poids sera inférieur ou égal à dix grammes.
f) il comporte des liaisons électriques 16a et 16b qui sont tracées précisément, grâce à la pièce adhésive 18 qui permet d'utiliser le procédé de connexion électrique point à point «wire bonding» existant et permet d'encaisser les contraintes mécaniques dues à ce procédé.
g) ce module d'éclairage comporte un nombre de pièces réduit contrairement à des solutions qui nécessitent une pièce supplémentaire pour la fixation mécanique et une autre pièce pour une dissipation thermique supplémentaire.

Enfin, la fabrication du module d'éclairage 1 n'entraîne pas d'importants coûts d'investissement. En effet, lors d'une nouvelle conception «design» d'un module d'éclairage 1 entraînant un nouveau design de la plaque conductrice 15 et de l'emplacement des dispositifs de lumière 10 dans cette plaque conductrice 15, il faut juste faire une reprogrammation de machine qui effectue le «wire bonding» contrairement à une solution qui nécessiterait de créer de nouveaux moules. Il suffit de reprogrammer uniquement la trajectoire des tracés de fil pour les connexions électriques. Ainsi, le fait d'ajouter la pièce adhésive 18 entraîne de faibles coûts d'investissement. Cette solution de module d'éclairage 1 est facile à mettre en oeuvre, mais également intéressante pour les petits volumes de production de modules d'éclairage 1 (et bien sûr pour les gros volumes).

## Revendications

1. Dispositif d'éclairage ou de feu (2) pour véhicule, comprenant un module d'éclairage (1) comprenant :
- au moins un dispositif de lumière (10) comprenant au moins une unité d'émission de lumière (11),
- deux terminaisons électriques (13a, 13b) connectées à l'unité d'émission de lumière (11),
- une plaque conductrice (15) comprenant une cavité (15a) pour recevoir le dispositif de lumière (10),
**caractérisé en ce qu**e le module d'éclairage comporte en outre :
- un support dissipateur de chaleur (17) du dispositif de lumière (10),
- un pièce adhésive (18) placée entre le support dissipateur (17) et la plaque conductrice (15),
**et en ce que** les deux terminaisons électriques (13a, 13b) sont connectées à la plaque conductrice (15) par connexion filaire(16a, 16b) point à point.

2. Dispositif d'éclairage ou de feu (2) selon la revendication précédente, **caractérisé en ce que** ladite cavité (15a) est traversante, de manière à ce que ledit dispositif de lumière (10) adhère à la dite pièce adhésive (18).

3. Dispositif d'éclairage ou de feu (2) selon l'une des revendications précédentes, **caractérisé en ce que** la pièce adhésive (18) se présente sous forme d'une feuille.

4. Dispositif d'éclairage ou de feu (2) selon l'une des revendications précédentes, **caractérisé en ce que** la pièce adhésive (18) est adhésive double face.

5. Dispositif d'éclairage ou de feu (2) selon l'une des revendications précédentes, **caractérisé en ce que** la pièce adhésive (18) permet d'assembler le dispositif de lumière (10) sur le support dissipateur (17) de manière précise.

6. Dispositif d'éclairage ou de feu (2) selon l'une des revendications précédentes, **caractérisé en ce que** la pièce adhésive (18) est composée d'un matériau pouvant adhérer uniquement par pression.

7. Dispositif d'éclairage ou de feu (2) selon l'une des revendications précédentes, **caractérisé en ce que** la pièce adhésive (18) est composée d'une base acrylique, d'un film en polyéthylène naphtalate ou d'un film en polyéthylène téréphtalate.

8. Dispositif d'éclairage ou de feu (2) selon la revendication 7, **caractérisé en ce que** la pièce adhésive (18) est composée d'une base acrylique comprenant des charges céramiques.

9. Dispositif d'éclairage ou de feu (2) selon l'une des revendications précédentes, **caractérisé en ce qu'**il comporte en outre une couche de colle (19) disposée dans la cavité (15a) autour du dispositif de lumière (10).

10. Dispositif d'éclairage ou de feu (2) selon la revendication 9, **caractérisé en ce que** ladite couche de colle est une colle se solidifiant à température ambiante.

11. Dispositif d'éclairage ou de feu (2) selon la revendication 9, **caractérisé en ce que** ladite couche de colle est une colle époxy ou un mastic polyester.

12. Dispositif d'éclairage ou de feu (2) selon l'une des revendications 1 à 8, **caractérisé en ce que** le dispositif de lumière (10) comporte en outre un segment isolé (20) pour une fixation mécanique sur la plaque conductrice (15) ou sur le support dissipateur (17).

13. Dispositif d'éclairage ou de feu (2) selon l'une des revendications précédentes, **caractérisé en ce que** le support dissipateur (17) comporte un radiateur à ailettes.

14. Dispositif d'éclairage ou de feu (2) selon l'une des revendications précédentes, **caractérisé en ce que** le support dissipateur (17) comporte une couche graphite.

15. Dispositif d'éclairage ou de feu (2) selon la revendication 5, **caractérisé en ce que** le graphite est anisotrope.

16. Dispositif d'éclairage ou de feu (2) selon l'une des revendications précédentes, **caractérisé en ce que** la plaque conductrice (15) comporte deux mires de positionnement (15b, 15c).

17. Dispositif d'éclairage ou de feu (2) selon l'une des revendications précédentes, **caractérisé en ce qu'**il comporte une pluralité de dispositifs de lumière (10).

## Patentansprüche

1. Beleuchtungsvorrichtung oder Scheinwerfer (2) für ein Kraftfahrzeug mit einem Beleuchtungsmodul (1), umfassend:
- mindestens eine Lichtvorrichtung (10) mit mindestens einer Lichtemissionseinheit (11),
- zwei elektrische Abschlüsse (13a, 13b), die mit der Lichtemissionseinheit (11) verbunden sind,
- eine leitfähige Platte (15), die eine Kavität (15a) zum Aufnehmen der Lichtvorrichtung (10) aufweist,
**dadurch gekennzeichnet, dass** das Beleuchtungsmodul ferner aufweist:
- einen die Wärme der Lichtvorrichtung (10) ableitenden Träger (17),
- ein Klebeteil (18), das zwischen dem ableitenden Träger (17) und der leitfähigen Platte (15) angeordnet ist,
und dass die beiden elektrischen Abschlüsse (13a, 13b) mit der leitfähigen Platte (15) über eine Punk-zu-Punkt-Drahtverbindung (16a, 16b) verbunden sind.

2. Beleuchtungsvorrichtung oder Scheinwerfer (2) nach dem vorhergehenden Anspruch, **dadurch gekennzeichnet, dass** die Kavität (15a) durchgehend ist, so dass die Lichtvorrichtung (10) an dem Klebeteil (18) klebt.

3. Beleuchtungsvorrichtung oder Scheinwerfer (2) nach einem der vorhergehenden Ansprüche, **dadurch gekennzeichnet, dass** das Klebeteil (18) in Form einer Folie vorliegt.

4. Beleuchtungsvorrichtung oder Scheinwerfer (2) nach einem der vorhergehenden Ansprüche, **dadurch gekennzeichnet, dass** das Klebeteil (18) doppelseitig klebt.

5. Beleuchtungsvorrichtung oder Scheinwerfer (2) nach einem der vorhergehenden Ansprüche, **dadurch gekennzeichnet, dass** das Klebeteil (18) es ermöglicht, die Lichtvorrichtung (10) präzise auf dem ableitenden Träger (17) anzubringen.

6. Beleuchtungsvorrichtung oder Scheinwerfer (2) nach einem der vorhergehenden Ansprüche, **dadurch gekennzeichnet, dass** das Klebeteil (18) aus einem Material besteht, das nur bei Druck kleben kann.

7. Beleuchtungsvorrichtung oder Scheinwerfer (2) nach einem der vorhergehenden Ansprüche, **dadurch gekennzeichnet, dass** das Klebeteil (18) aus einer Acrylbasis, einer Polyethylennaphthalatfolie oder einer Polyethylenterephthalatfolie besteht.

8. Beleuchtungsvorrichtung oder Scheinwerfer (2) nach Anspruch 7, **dadurch gekennzeichnet, dass** das Klebeteil (18) aus einer Acrylbasis besteht, die keramische Füllstoffe umfasst.

9. Beleuchtungsvorrichtung oder Scheinwerfer (2) nach einem der vorhergehenden Ansprüche, **dadurch gekennzeichnet, dass** sie ferner eine Klebstoffschicht (19) umfasst, die in der Kavität (15a) um die Lichtvorrichtung (10) herum angeordnet ist.

10. Beleuchtungsvorrichtung oder Scheinwerfer (2) nach Anspruch 9, **dadurch gekennzeichnet, dass** die Klebstoffschicht ein Klebstoff ist, der sich bei Umgebungstemperatur verfestigt.

11. Beleuchtungsvorrichtung oder Scheinwerfer (2) nach Anspruch 9, **dadurch gekennzeichnet, dass** der Klebstoff ein Epoxidharzklebstoff oder eine Polyesterspachtelmasse ist.

12. Beleuchtungsvorrichtung oder Scheinwerfer (2) nach einem der Ansprüche 1 bis 8, **dadurch gekennzeichnet, dass** die Lichtvorrichtung (10) ferner ein isoliertes Segment (20) für eine mechanische Befestigung auf der leitfähigen Platte (15) oder auf dem ableitenden Träger (17) aufweist.

13. Beleuchtungsvorrichtung oder Scheinwerfer (2) nach einem der vorhergehenden Ansprüche, **dadurch gekennzeichnet, dass** der ableitende Träger (17) einen Lamellenkühlkörper aufweist.

14. Beleuchtungsvorrichtung oder Scheinwerfer (2) nach einem der vorhergehenden Ansprüche, **dadurch gekennzeichnet, dass** der ableitende Träger (17) eine Graphitschicht aufweist.

15. Beleuchtungsvorrichtung oder Scheinwerfer (2) nach Anspruch 5, **dadurch gekennzeichnet, dass** der Graphit anisotrop ist.

16. Beleuchtungsvorrichtung oder Scheinwerfer (2) nach einem der vorhergehenden Ansprüche, **dadurch gekennzeichnet, dass** die leitfähige Platte (15) zwei Positionierungsmarken (15b, 15c) aufweist.

17. Beleuchtungsvorrichtung oder Scheinwerfer (2) nach einem der vorhergehenden Ansprüche, **dadurch gekennzeichnet, dass** sie eine Vielzahl von Lichtvorrichtungen (10) aufweist.

## Claims

1. Lighting or headlamp device (2) for a vehicle, comprising a lighting module (1) comprising:
- at least one light device (10) comprising at least one light-emitting unit (11),
- two electric terminals (13a, 13b) connected to the light-emitting unit (11),
- a conductive plate (15) comprising a cavity (15a) for receiving the light device (10),
**characterized in that** the lighting module further comprises:
- a heat sink support (17) for the light device (10),
- an adhesive part (18) placed between the heat sink support (17) and the conductive plate (15),
**and in that** the two electric terminals (13a, 13b) are connected to the conductive plate (15) by a point-to-point wire connection (16a, 16b).

2. Lighting or headlamp device (2) according to the preceding claim, **characterized in that** said cavity (15a) is a through-cavity such that said light device (10) adheres to said adhesive part (18).

3. Lighting or headlamp device (2) according to either of the preceding claims, **characterized in that** the adhesive part (18) is in the form of a sheet.

4. Lighting or headlamp device (2) according to one of the preceding claims, **characterized in that** the adhesive part (18) is adhesive on both sides.

5. Lighting or headlamp device (2) according to one of the preceding claims, **characterized in that** the adhesive part (18) makes it possible to assemble the light device (10) on the heat sink support (17) in a precise manner.

6. Lighting or headlamp device (2) according to one of the preceding claims, **characterized in that** the adhesive part (18) consists of a material that can adhere solely by pressure.

7. Lighting or headlamp device (2) according to one of the preceding claims, **characterized in that** the adhesive part (18) consists of an acrylic base, a film of polyethylene naphthalate or a film of polyethylene terephthalate.

8. Lighting or headlamp device (2) according to Claim 7, **characterized in that** the adhesive part (18) consists of an acrylic base comprising ceramic fillers.

9. Lighting or headlamp device (2) according to one of the preceding claims, **characterized in that** it further comprises a layer of glue (19) arranged in the cavity (15a) around the light device (10).

10. Lighting or headlamp device (2) according to Claim 9, **characterized in that** said layer of glue is a glue that cures at ambient temperature.

11. Lighting or headlamp device (2) according to Claim 9, **characterized in that** said layer of glue is an epoxy glue or a polyester mastic.

12. Lighting or headlamp device (2) according to one of Claims 1 to 8, **characterized in that** the light device (10) further comprises an insulated segment (20) for mechanical attachment to the conductive plate (15) or to the heat sink support (17).

13. Lighting or headlamp device (2) according to one of the preceding claims, **characterized in that** the heat sink support (17) comprises a finned radiator.

14. Lighting or headlamp device (2) according to one of the preceding claims, **characterized in that** the heat sink support (17) comprises a graphite layer.

15. Lighting or headlamp device (2) according to Claim 5, **characterized in that** the graphite is anisotropic.

16. Lighting or headlamp device (2) according to one of the preceding claims, **characterized in that** the conductive plate (15) comprises two positioning sights (15b, 15c).

17. Lighting or headlamp device (2) according to one of the preceding claims, **characterized in that** it comprises a plurality of light devices (10).
